Europäisches Patentamt

European Patent Office

Office européen des brevets

(11) Veröffentlichungsnummer: **0 090 215**
A2

# (12) EUROPÄISCHE PATENTANMELDUNG

(21) Anmeldenummer: 83102318.9

(51) Int. Cl.³: **G 02 F 1/133**

(22) Anmeldetag: 09.03.83

(30) Priorität: 25.03.82 DE 3211066

(43) Veröffentlichungstag der Anmeldung: 05.10.83
Patentblatt 83/40

(84) Benannte Vertragsstaaten: **DE FR GB IT**

(71) Anmelder: **SIEMENS AKTIENGESELLSCHAFT, Berlin und München Wittelsbacherplatz 2, D-8000 München 2 (DE)**

(72) Erfinder: **Kohlmüller, Hans, Friedrich-Bauer-Strasse 5, D-8520 Erlangen (DE)**
Erfinder: **Nippe, Waldemar, Dr., Philipp-Reis-Strasse 40, D-8520 Erlangen (DE)**

(54) **Transparente Leitschicht.**

(57) Die Erfindung betrifft eine transparente Leitschicht auf der Basis von Zinn- und/oder Indiumoxid und stellt sich die Aufgabe, eine Leitschicht dieser Art in der Weise auszugestalten, daß sie elektrochemischen Angriffen widersteht, ohne daß dazu aufwendige Maßnahmen erforderlich sind. Die Erfindung sieht dazu vor, daß die Leitschicht wenigstens ein Metall der ersten und/oder achten Nebengruppe mit einem Gehalt zwischen $10^{-3}$ und 3 Gew.-%, bezogen auf Zinn- und Indiumoxid, enthält. Die erfindungsgemäße Leitschicht eignet sich insbesondere zur Verwendung in Flüssigkristalldisplays.

0090215

SIEMENS AKTIENGESELLSCHAFT     Unser Zeichen
Berlin und München            VPA **82 P 3 0 8 7 E**

## Transparente Leitschicht

Die Erfindung betrifft eine transparente Leitschicht auf der Basis von Zinn- und/oder Indiumoxid sowie ein Verfahren zur Herstellung einer derartigen Leitschicht.

Alle Arten von passiven Displays, wie elektrochrome Displays, elektrolytische Displays und Flüssigkristalldisplays, benötigen transparente leitende Elektroden, wozu im allgemeinen mit transparenten Leitschichten versehene Gläser dienen. Die Leitschichten bestehen dabei vorwiegend aus Zinn- und/oder Indiumoxid. Bei elektrochromen und elektrolytischen Displays erfolgt die Anzeige aufgrund von elektrochemischen Reaktionen. Dabei ist es möglich, daß die Leitschichten an diesen Reaktionen beteiligt werden, und somit besteht die Gefahr einer (raschen) Zerstörung der Leitschichten. Dies kann insbesondere durch eine elektrochemische Reduktion der in den Leitschichten enthaltenen Oxide erfolgen.

Bei (Feldeffekt-)Flüssigkristalldisplays dient zur Anzeige ein elektrisches Feld. Hierbei wären demnach keine nachteiligen Reaktionen zu erwarten, wenn Flüssigkristalle ideale Isolatoren wären. Da Flüssigkristalle aber einen endlichen Widerstand besitzen, treten auch in diesen Displays elektrochemische Reaktionen auf. Diese Reaktionen laufen - innerhalb der Displays - an der Grenzfläche Elektrode/Flüssigkristall ab und führen, da sie wegen der hohen Feldstärke bevorzugt an den Segmentkanten auftreten, über

Bh 2 Koe / 23.3.1982

0090215

eine Kantendesorientierung bis zu einer Verfärbung der gesamten transparenten Elektroden, hervorgerufen durch metallisches Zinn bzw. Indium.

Außerhalb der eigentlichen Anzeigevorrichtung kann es bei ungünstigen Umgebungsbedingungen zur Bildung eines Wasserfilmes kommen, und insbesondere in Spalten kann eine Kapillarkondensation erfolgen. Da der Wasserfilm infolge von Verunreinigungen der Luft leitend ist, sind auch hierbei die Voraussetzungen für das Auftreten elektrochemischer Reaktionen geschaffen, die zur Zerstörung der aus Zinn- und/oder Indiumoxid bestehenden Leiterbahnen führen können. Diese Leiterbahnen, die mit den einzelnen Segmenten und Symbolen des Displays verbunden sind, werden zur Ansteuerung benötigt.

Die Zerstörung der Leiterbahnen kann bei allen Arten von Displays auftreten. Es ist auch bereits versucht worden, diesen Prozeß zu verzögern oder ganz zu unterbinden, insbesondere durch die Verwendung von besonders widerstandsfähigen Materialien. Außerdem wird darauf geachtet, daß keine Spalten vorhanden sind, in denen eine Kapillarkondensation erfolgen kann. Alle diese Maßnahmen sind jedoch aufwendig und haben nicht den erwünschten Erfolg gebracht. Eine andere Maßnahme zur Verhinderung von elektrochemischen Reaktionen, nämlich die Abdeckung der Leiterbahnen mit einem Schutzlack, ist - wegen der an den Leiterbahnen stets erforderlichen Kontaktierung - nur bedingt möglich und deshalb nur in eingeschränktem Maße wirksam.

Die innerhalb der Anzeigevorrichtungen erfolgende Zerstörung der Elektroden wird bei Flüssigkristalldisplays durch eine hinreichend hohe Ansteuerfrequenz zu unterbinden versucht. Dabei ist jedoch Voraussetzung, daß die Elektrodenreaktionen reversibel verlaufen. Zur Realisierung dieses Ziels wurde bereits vorgeschlagen, den Flüssigkristallen in geringen Mengen einen oxidierbaren bzw. reduzierbaren Elektronen-Donor-Akzeptor-Komplex zuzusetzen (vgl.: deutsche Patentanmeldung Akt.Z. P 30 42 517.3 - VPA 80 P 7580 DE, "Flüssigkristallanzeige") oder unmittelbar Flüssigkristallkomponenten mit Elektronen-Donor-Akzeptor-Eigenschaften zu verwenden (vgl.: deutsche Patentanmeldung Akt.Z. P 31 25 758.5 - VPA 81 P 7540 DE, "Flüssigkristallanzeige"). Durch die genannten Maßnahmen kann die Elektrodenpolarisation bei dem durch Umwelteinflüsse vorgegebenen Strom verringert werden und damit wird die Voraussetzung dafür geschaffen, daß die durch diesen Strom bedingten Reaktionen an den Elektroden reversibel verlaufen.

Die genannten Maßnahmen sind so wirkungsvoll, daß sogar ein Gleichstrombetrieb von Flüssigkristalldisplays ermöglicht wird. Bei der Verwendung von Zusätzen kann allerdings nicht ganz ausgeschlossen werden, daß in bestimmten Einzelfällen eine Beeinträchtigung der Flüssigkristalle erfolgt. Auf der anderen Seite ist zumindest derzeit die Auswahl an Flüssigkristallen mit Elektronen-Donor-Akzeptor-Eigenschaften noch begrenzt.

Bei elektrochromen und elektrolytischen Displays wird versucht, die Zerstörung der Elektroden dadurch zu verhindern, daß die Elektrodenränder mit einer chemisch inerten Schicht abgedeckt werden (vgl.: DE-OS 23 01 580). Eine derartige Maßnahme ist jedoch in fertigungstechnischer Hinsicht sehr aufwendig.

Aufgabe der Erfindung ist es, eine transparente Leitschicht auf der Basis von Zinn- und/oder Indiumoxid in der Weise auszugestalten, daß sie elektrochemischen Angriffen widersteht, ohne daß dazu aufwendige Maßnahmen erforderlich sind.

Dies wird erfindungsgemäß dadurch erreicht, daß die Leitschicht wenigstens ein Metall der ersten und/oder achten Nebengruppe mit einem Gehalt zwischen $10^{-3}$ und 3 Gew.-%, bezogen auf Zinn- und Indiumoxid, enthält.

Die erfindungsgemäßen Leitschichten weisen durch den Einbau geringer Mengen wenigstens eines Metalls der ersten und/oder achten Nebengruppe eine gesteigerte Stabilität auf, d.h. sie sind elektrochemisch resistent. Dies gilt sowohl für zinnoxid- als auch für indiumoxidhaltige Schichten und gleichermaßen für sogenannte ITO- Schichten, d.h. für Schichten, die sowohl Zinn- als auch Indiumoxid aufweisen. Dabei ist insbesondere wesentlich, daß die erfindungsgemäßen Leitschichten auch dann stabil sind, wenn sie sehr dünn sind.

Die Stabilisierung wird durch Metalle der ersten und achten Nebengruppe des sogenannten Periodischen Systems der Elemente erreicht. Hierbei handelt es sich einerseits um die Elemente Kupfer, Silber und Gold (1. Nebengruppe) und andererseits um die Elemente Eisen, Kobalt und Nickel sowie um die Platinmetalle, d.h. um die Elemente Ruthenium, Rhodium, Palladium, Osmium, Iridium und Platin (8. Nebengruppe). Die erfindungsgemäßen Leitschichten weisen dabei bevorzugt einen geringen Gehalt an Platin auf.

Die erfindungsgemäßen Leitschichten, bei denen in einer transparenten Schicht aus Zinn- und/oder Indiumoxid ein Metall, wie Platin, eingelagert ist, können als Elektroden in elektrooptischen Anzeigevorrichtungen dienen; dabei finden sie insbesondere in Flüssigkristalldisplays Verwendung. Derartige Elektroden werden durch das eingelagerte Metall stabilisiert und bieten den Vorteil, daß nicht, wie sonst üblich, aufwendige Maßnahmen getroffen werden müssen, um eine Zerstörung der Elektroden zu verhindern.

Zur Herstellung der erfindungsgemäßen Leitschichten wird in das Zinn- bzw. Indiumoxid wenigstens ein Metall der ersten und/oder achten Nebengruppe eingebracht. Dies kann entweder bei der Herstellung der Leitschicht oder nach deren Fertigstellung geschehen. Erfolgt der Einbau des Metalls bereits beim Herstellungsprozeß, so kann die erfindungsgemäße Leitschicht beispielsweise durch Sputtern hergestellt und dabei ein Target verwendet werden, das das entsprechende Metall enthält. Dadurch ist es möglich, die zur Stabilisierung erforderliche Menge an Metall in die Leitschicht einzubringen. Leitschichten können ferner nach dem sogenannten CVD-Verfahren ("Chemical Vapour Deposition") hergestellt werden. Auch hierbei ist es möglich, gleichzeitig das gewünschte Metall mit in die Schicht einzubauen.

Wird das Metall in die bereits gefertigte Leitschicht eingebracht, so kann dies vorteilhaft durch elektrolytische Abscheidung des Metalls geschehen, d.h. auf elektrochemischem Weg. Die Metallabscheidung erfolgt dabei vorzugsweise aus sehr verdünnten Lösungen und insbesondere mittels Wechselstrom; die Stromdichte beträgt vorteilhaft etwa zwischen 0,01 und 0,1 mA/cm$^2$. Durch die Verwendung von Wechselstrom wird erreicht, daß das Metall direkt in die Leitschicht eingelagert wird. Bei der Verwendung von Gleichstrom wird auf der Leitschicht zunächst eine Metallschicht gebildet, und nachfolgend wird dann das Metall in die Leitschicht eingebracht, im allgemeinen durch Tempern.

Die Abscheidung des Metalls auf der Leitschicht kann aber auch auf chemischem Weg erfolgen, d.h. durch Reduktion eines Metallsalzes. Vorteilhaft kann die erfindungsgemäße Leitschicht ferner in der Weise hergestellt werden, daß das Metall durch Sputtern in dünner Schicht auf die Leitschicht aufgebracht und nachfolgend durch Tempern in die Schicht eingelagert wird. Geht man dabei beispielsweise von Leitschichten mit einer Dicke von 300 nm aus, so werden mittels Sputtern Metallschichten mit einer Dicke zwischen 0,01 und 10 nm erzeugt. Der Temperprozeß findet dann etwa bei 300°C statt.

Anhand von Beispielen soll die Erfindung noch näher erläutert werden.

Bei Flüssigkristalldisplays wird die Zerstörung der Leitschichten durch quasigalvanostatische Vorgänge ausgelöst, denn der über die Zelle fließende Strom wird in erster Linie durch hochohmige Schichten (innerhalb der Displays: Flüssigkristalle; außerhalb der Displays: Wasserfilme) und die Ansteuerspannung begrenzt. Da die Ansteuerspannung im Vergleich zur Elektrodenpolarisation groß ist und der Widerstand der den Strom begrenzenden Schichten (Flüssigkristalle bzw. Wasserfilme) annähernd konstant, kann mit einem für die Zerstörung der Leitschichten verantwortlichen konstanten Strom gerechnet werden. Diesem Sachverhalt wird durch folgenden Meßaufbau Rechnung getragen.

0090215

In einer Zelle mit einer Bezugs- und einer Gegenelektrode befindet sich eine mit einer leitenden Indiumoxid/ Zinnoxid-Schicht (ITO-Schicht) versehene Glasplatte als Arbeitselektrode. Als Elektrolyt dient 1 M KCl (in Wasser). Die Verwendung einer wäßrigen Kaliumchloridlösung als Elektrolyt erlaubt den Einsatz einer sehr einfach aufgebauten Ag/AgCl-Elektrode als Bezugselektrode. Die Gegenelektrode besteht aus einem platinierten Platinblech.

Die Gegenelektrode und die Arbeitselektrode sind mit einer Spannungsquelle verbunden. Der über die Zelle fließende Strom wird durch einen Widerstand R zwischen Spannungsquelle und Gegenelektrode begrenzt. Mittels eines Stufenschalters kann der Widerstand R zwischen 1 k$\Omega$ und 100 k$\Omega$ variiert werden. Durch die relativ hohe Ansteuerspannung von 30 $V_{pp}$ (bei 1 Hz) ist der über die Zelle fließende Strom nahezu konstant. "$V_{pp}$" bedeutet dabei die Spannung (des Wechselstroms) zwischen den beiden Spitzen ("peak"); 30 $V_{pp}$ entsprechen etwa 10 V Wechselspannung.

Die Wechselspannung zwischen der Bezugselektrode und der Arbeitselektrode wird mit einer Diode gleichgerichtet und über einen Kondensator (C = 10 $\mu$F) geglättet und dann mittels eines Schreibers registriert. Die zwischen der ITO-Schicht, d.h. der Arbeitselektrode (Fläche: ca. 2 cm$^2$), und der Bezugselektrode liegende Spannung steigt bei der Zerstörung der Leitschicht etwa auf den Wert der Ansteuerspannung an. Beim Zerstören der Leitschicht wird nämlich deren Widerstand sehr groß (bis unendlich), so daß die Spannung am Kondensator gleich der Ansteuerspannung wird.

0090215

Bei dem erläuterten Vorgehen, das als sogenannter Streßtest bezeichnet wird, wird als Ende der Lebensdauer somit das Ansteigen der Spannung am Kondensator angesehen. Am Ende der Lebensdauer weisen die Leitschichten außerdem meistens einen Metallspiegel auf, der die Transmission beeinflußt. Im allgemeinen erfolgt der Streßtest mit einer Rechteckspannung von 30 $V_{pp}$ und 1 Hz sowie einem Widerstand von 3 k$\Omega$. Bei besonders stabilen Schichten kann dieser Test verschärft werden. Anstelle eines Widerstandes von 3 k$\Omega$ wird dann ein Widerstand von 1 k$\Omega$ zur Begrenzung des Stromes verwendet. In den meisten Fällen wirkt sich diese Widerstandsveränderung überproportional aus: Es kommt zu einer Verkürzung der Lebensdauer im Bereich von einer Größenordnung (Faktor 10).

In eine (unvorbehandelte) ITO-Schicht wird erfindungs-gemäß Platin eingebracht. Dazu wird die ITO-Schicht zusammen mit einer Gegenelektrode in einer Zelle ange-ordnet; Elektrolyt: 1 M KCl + $10^{-4}$ M $H_2PtCl_6$ (in Wasser). Die Abscheidung des Platins erfolgt mittels Rechteckwechselstrom (1 Hz, 0,1 mA/cm$^2$); Dauer: 2 h. Die mit Platin dotierte Leitschicht zeigt keine Veränderungen bezüglich der Transparenz.

Die unbehandelte Leitschicht weist im Streßtest lediglich eine Lebensdauer von ca. 20 s auf. Im Vergleich dazu erhöht sich die Lebensdauer der Pt-dotierten Leitschicht auf mehr als 10 000 s, d.h. diese Schicht ist im (normalen) Streßtest praktisch nicht mehr zerstörbar. Die Tatsache, daß bereits sehr geringe Platinmengen eine merkliche Stabilisierung der Leitschicht bewirken, zeigt sich in folgendem. Beträgt die Abscheidedauer bei den obengenannten Bedingungen lediglich 2 min, so erfolgt im Streßtest bereits eine Erhöhung der Lebensdauer um den Faktor 10.

Mittels einer Sputteranlage (Abscheidungsgeschwindigkeit bei einem Abstand von 3 cm: 10 nm/min; minimale
Sputterzeit: 15 s) wurden auf unbehandelten ITO-Schichten dünne Metallschichten aufgebracht. Es wurden Leitschichten mit folgenden Schichten versehen:
Probe 1: 2 nm Pt (Sputterzeit: 15 s, Abstand: 3 cm);
Probe 2: 3 nm Pt (Sputterzeit: 20 s, Abstand: 3 cm);
Probe 3: 0,5 nm Pt (Sputterzeit: 15 s, Abstand: 6 cm).
Die Proben wurden anschließend bei 300$^{o}$C getempert.

Während die Lebensdauer unbehandelter Proben im normalen Streßtest bei 20 s liegt, weist Probe 3 eine Lebensdauer von 500 s auf. Die Proben 1 und 2 zeigten im
verschärften Streßtest eine Lebensdauer von über 1000 s.

6 Patentansprüche

Patentansprüche

1. Transparente Leitschicht auf der Basis von Zinn- und/oder Indiumoxid, d a d u r c h   g e k e n n - z e i c h n e t ,   daß sie wenigstens ein Metall der ersten und/oder achten Nebengruppe mit einem Gehalt zwischen $10^{-3}$ und 3 Gew.-%, bezogen auf Zinn- und Indiumoxid, enthält.

2. Transparente Leitschicht nach Anspruch 1, d a d u r c h   g e k e n n z e i c h n e t ,   daß sie Platin enthält.

3. Verfahren zur Herstellung einer transparenten Leitschicht nach Anspruch 1 oder 2,   d a d u r c h g e k e n n z e i c h n e t ,   daß in das Zinn- bzw. Indiumoxid wenigstens ein Metall der ersten und/oder achten Nebengruppe eingebracht wird.

4. Verfahren nach Anspruch 3,   d a d u r c h g e k e n n z e i c h n e t ,   daß das Metall durch elektrolytische Abscheidung in eine Schicht aus Zinn- und/oder Indiumoxid eingebracht wird.

5. Verfahren nach Anspruch 3,   d a d u r c h g e k e n n z e i c h n e t ,   daß das Metall durch Sputtern in dünner Schicht auf eine Schicht aus Zinn- und/oder Indiumoxid aufgebracht und nachfolgend durch Tempern in diese Schicht eingebracht wird.

6. Verwendung der transparenten Leitschicht nach Anspruch 1 oder 2 als Elektrode in elektrooptischen Anzeigevorrichtungen, insbesondere Flüssigkristall- displays.